# EUROPEAN PATENT SPECIFICATION

(11) **EP 3 220 090 B1**
(45) Date of publication and mention of the grant of the patent: **16.10.2019**
(21) Application number: 14905862.0
(22) Date of filing: 10.11.2014
(51) Int. Cl.: F28D 15/02, H01L 23/427

(54) **HEAT SINK**
KÜHLKÖRPER
DISSIPATEUR THERMIQUE

(43) Date of publication of application: 20.09.2017
(73) Proprietor: Furukawa Electric Co., Ltd., Chiyoda-ku Tokyo 100-8322 (JP)
(72) Inventor: HIRASAWA, Takeshi, Tokyo 100-8322 (JP); SASAKI, Chiyoshi, Tokyo 100-8322 (JP); IKEDA, Masami, Tokyo 100-8322 (JP)
(74) Representative: Forstmeyer, Dietmar
(86) International application number: PCT/JP2014/079749
(87) International publication number: WO 2016/075742

(56) References cited:
- JP-A- H 047 860
- JP-A- H09 210 583
- JP-A- 2003 234 443
- JP-A- 2008 311 282
- JP-U- S5 852 467
- US-A1- 2010 139 892

## Description

### Technical Field

The present invention relates to a heat sink in which radiation fin parts are provided to a plurality of heat pipes closely disposed to one another. JP H04 7860 A for instance discloses a heat sink with the features of the preamble of claim 1.

### Background Art

There is known one among heat sinks that adjusts cooling performance by changing the number of fin plates attached to each heat pipe (for example, see Patent Literature 1). Nevertheless, change of the number of fin plates requires an installation space for the number of fin plates. Although it can be otherwise considered that the distance between the fin plates is made narrow to increase the number of fin plates, since the narrow distance between the fin plates makes air difficult to flow therethrough, cooling efficiency is not much improved, or cooling efficiency deteriorates.

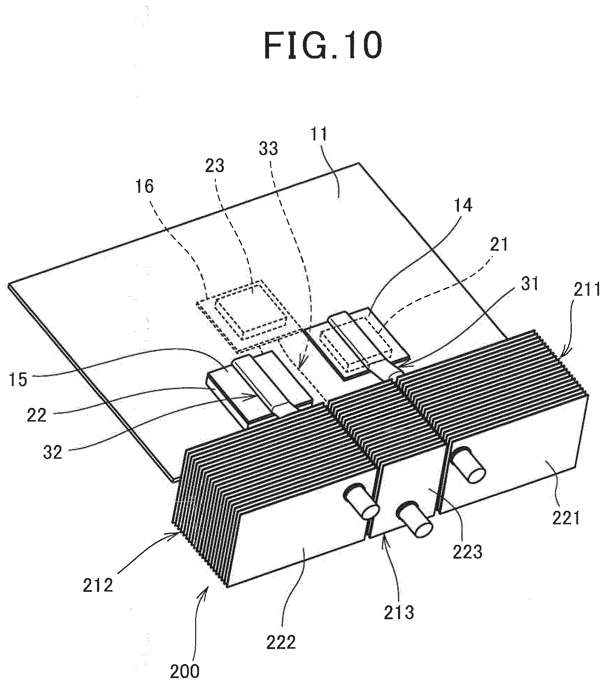

As to heat pipes shown in Patent Literature 1, when adjacent heat pipes are closely disposed to each other, for example, due to restriction in shape, in order to adjust cooling performance for each heat pipe, there is a method in which fin plates are divided into rectangles between the heat pipes as shown in FIG. 10.

FIG. 10 is a perspective view showing a conventional heat sink 200.

In FIG. 10, the heat sink 200 is constituted of heat receiving plates 14 and 15 thermally connected respectively to a first element 21 and a second element 22 which are disposed on one face of a circuit board 11, a heat receiving plate 16 thermally connected to a third element 23 disposed on the other face of the circuit board 11, heat pipes 31, 32 and 33 whose one ends are attached respectively to these heat receiving plates 14, 15 and 16, and radiation fin parts 211, 212 and 213 attached respective to the other ends of these heat pipes 31, 32 and 33.

The radiation fin parts 211, 212 and 213 are composed of respective pluralities of rectangular fin plates 221, 222 and 223.

Moreover, in FIG. 10, the heat pipes 31 and 32 can be bent rightward and leftward to widen the distance between the heat pipes 31 and 32 and to make the areas of the fin plates 221, 222 and 223 approximately equivalent to one another.

### Citation List

### Patent Literature

Patent Literature 1: Japanese Patent Laid-Open No. 7-190655

### Summary of Invention

### Technical Problem

As mentioned above, when the fin plates 221, 222 and 223 are divided as rectangles, the fin plate 223 disposed on the center side out of the fin plates 221, 222 and 223 is narrow in width and difficult to secure an area required for radiation. Moreover, the fin plates 221 and 222 disposed outside are to have areas excess to the area required for radiation. As a result, the heat pipe 33 on the center side cannot be sufficiently cooled, and the temperature of the third element 23 connected to the heat pipe 33 sometimes exceeds the allowable maximum temperature. Moreover, differences between the allowable maximum temperature and the temperatures of the elements 21, 22 and 23 become large between the elements 21, 22 and 23.

Accordingly, it is desired to reduce the maximum temperature of the third element 23 and to more reduce the differences between the allowable maximum temperature and the temperatures of the elements 21, 22 and 23 between the elements 21, 22 and 23. This needs optimization of the areas of the fin plates 221, 222 and 223.

Moreover, when the heat pipes 31 and 32 are bent rightward and leftward to widen the distance between the heat pipes 31 and 32, the fin plates 221, 222 and 223 sometimes interfere with the pipe bending parts. Since the fin plates 221, 222 and 223 cannot be fixed to the pipe bending parts, the fin plates 221, 222 and 223 cannot be inserted to the vicinity of the circuit board 11. This causes decrease of the number of fin plates and reduction of the areas, which can rather cause deterioration of radiation performance.

The present invention is devised in view of the aforementioned circumstances, and an object thereof is to optimize, in a heat sink including a plurality of heat pipes, the areas of fin plates provided to the heat pipes.

### Solution to Problem

In order to solve the aforementioned problem, there is provided a heat sink as defined in claim 1.

According to this configuration, the area of the fin plate of the radiation fin part is enlarged by the expanding part, the areas of the fin plates required for the heat pipes by nature can be given, and the areas of the fin plates can be optimized. As a result, cooling performance of the heat sink as an assembly can be improved.

Furthermore, since excess fin areas of the fin plates connected to the heat pipes can be reduced, the heat sink can be downsized as a whole.

In the aforementioned configuration, at least one side of the expanding part may be parallel to at least one side of each radiation fin part. According to this configuration, the fin plates can be efficiently disposed in the space.

Moreover, in the aforementioned configuration, at least one side of the expanding part may be oblique to at least one side of each radiation fin part.

Moreover, in the aforementioned configuration, a part of one side in the expanding part may be folded.

Moreover, in the aforementioned configuration, all the plurality of heat pipes are constituted of straight line shapes. According to this configuration, even when the heat pipe are closely disposed to one another into straight line shapes, not only the heat pipe but also the heat sink can be manufactured at low costs while cooling performance of the heat sink is improved.

### Advantageous Effects of Invention

There is provided a heat sink according to the present invention, including: a plurality of heat pipes; and radiation fin parts respectively corresponding to the plurality of heat pipes, the radiation fin parts being fixed to respective end parts of the plurality of heat pipes in a longitudinal direction, each of the plurality of radiation fin parts being composed of a plurality of fin plates, a gap being formed between adjacent fin plates, wherein the fin plate has a fixing part for thermal connection to the heat pipe, and at least one heat pipe is fixed to each fin plate, a fin plate assembly is constituted of the fin plates of the plurality of respective radiation fin parts as the plurality of radiation fin parts are seen from a direction in which the heat pipe extends, the plurality of heat pipes are composed of a first heat pipe group and a second heat pipe group, the first heat pipe group is positioned at a center in a longitudinal direction of the fin plate assembly, and the second heat pipe group is positioned on both sides of the first heat pipe group in the longitudinal direction of the fin plate assembly, and the fin plate thermally connected to the first heat pipe group includes an expanding part. Hence, the area of the fin plate of the radiation fin part can be enlarged by the expanding part, the areas of the fin plates required for the heat pipes by nature can be given, and the areas of the fin plates can be optimized. As a result, cooling performance of the heat sink as an assembly can be improved.

Furthermore, since excess fin plate areas of the fin plates connected to the heat pipes can be reduced, the heat sink can be downsized as a whole. Furthermore, since the fin contact parts of the heat pipes are not needed to be bent to widen the distances, when the one end parts of the heat pipes are attached to the circuit board part, the fin plates can be inserted to the circuit board part. Hence, the number of fin plates is not needed to be reduced, which leads to downsizing.

### Brief Description of Drawings

FIG. 1 is a perspective view showing a heat sink (Embodiment 1) of the present invention.
FIG. 2 is an elevation view showing fin plates (Embodiment 1).
FIGS. 3A and 3B are perspective views for explaining fin plates (Embodiment 1 and Modification). FIG. 3A is a perspective view showing the fin plate. FIG. 3B is a perspective view showing a fin plate that is a modification of that fin plate.
FIGS. 4A and 4B are operation diagrams for comparing operations in the presence and the absence of folded parts of the fin plate (Modification). FIG. 4A is an operation diagram showing operation of the fin plate. FIG. 4B is an operation diagram showing Modification of the fin plate.
FIG. 5 is a perspective view showing a heat sink (Embodiment 2) of the present invention.
FIG. 6 is an elevation view showing fin plates (Embodiment 2).
FIGS. 7A to 7C are elevation views showing fin plate shapes (Embodiment 3, Embodiment 4 and Embodiment 5) corresponding to three heat pipes that are arranged in one line. FIG. 7A is an elevation view showing Embodiment 3 in which each of fin plates is constituted of a plurality of rectangles. FIG. 7B is an elevation view showing Embodiment 4 in which fin plates are formed so as to expand from the inside to the outside. FIG. 7C is an elevation view showing Embodiment 5 in which one fin plate is formed so as to enclose the other fin plates.
FIG. 8 is an elevation view showing fin plate shapes (Embodiment 6) corresponding to four heat pipes that are arranged in one line.
FIGS. 9A and 9B are elevation views showing fin plate shapes (Embodiment 7 and Embodiment 8) corresponding to six heat pipes that are arranged in two lines. FIG. 9A is an elevation view showing Embodiment 7 in which each of fin plates is constituted of a single rectangle or a plurality of rectangles. FIG. 9B is an elevation view showing Embodiment 8 in which each of fin plates is formed so as to expand from the inside to the outside.
FIG. 10 is a perspective view showing a conventional heat sink.
FIG. 11 is an elevation view showing fin plates (Comparative Example 1) of the conventional art shown in FIG. 10.
FIG. 12 is an elevation view showing Comparative Example 2 which is a conventional art in which each fin plate is formed into a rectangle.
FIG. 13 is an elevation view showing Comparative Example 3 which is a conventional art in which each fin plate is formed into a rectangle.
FIG. 14 is an elevation view showing Comparative Example 4 which is a conventional art in which each fin plate is formed into a rectangle.

### Description of Embodiments

Hereafter, embodiments of the present invention are described with reference to the drawings.

### (Embodiment 1 and Comparative Example 1)

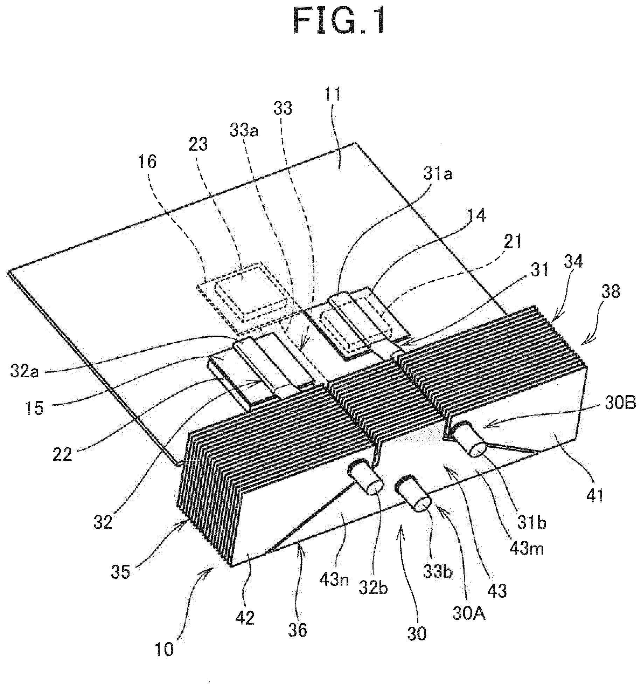

FIG. 1 is a perspective view showing a heat sink 10 (Embodiment 1) of the present invention.

The heat sink 10 is constituted of heat receiving plates 14 and 15 thermally connected respectively to a first element 21 and a second element 22 which are disposed on the upper face of a circuit board 11, a heat receiving plate 16 thermally connected to a third element 23 disposed on the lower surface of the circuit board 11, heat pipes 31, 32 and 33 whose one end parts 31a, 32a and 33a sides are attached respectively to these heat receiving plates 14, 15 and 16, and radiation fin parts 34, 35 and 36 attached respectively to the other end parts 31b, 32b and 33b sides of these heat pipes 31, 32 and 33. The radiation fin parts 34, 35 and 36 constitute a radiation part 38 whose overall external form is formed into a substantially solid rectangular shape, and the radiation fin parts 34, 35 and 36 are composed of respective pluralities of fin plates 41, 42 and 43. The aforementioned heat pipes 31, 32 and 33 extend in parallel or substantially parallel to one another and into straight line shapes, and constitute a heat pipe group 30.

The heat receiving plates 14, 15 and 16 are components of aluminum alloy plates whose surfaces are nickel-plated, and thermally connected respectively to the elements 21, 22 and 23 via grease.

The heat pipes 31, 32 and 33 are components of pipes made of highly thermal conductive material such, for example, as copper in which pipes working fluid is sealed, and those one end parts 31a, 32a and 33a which are formed to be flat are soldered respectively to the heat receiving plates 14, 15 and 16.

In the heat pipes 31, 32 and 33, the working fluid is vaporized in high temperature parts on the heat receiving plates 14, 15 and 16 sides, the working fluid vapor moves to low temperature parts on the radiation fin parts 34, 35 and 36 sides to be cooled and condensed into liquid, and it returns to the high temperature parts. Such recycling is repeated to conduct heat transfer from the high temperature parts to the low temperature parts.

The fin plates 41, 42 and 43 are made of aluminum alloy, and are fixed respectively to the heat pipes 31, 32 and 33 at a predetermined pitch by press fitting. Thereby, the fin plates 41, 42 and 43 are perpendicularly or substantially perpendicularly fixed respectively to the heat pipes 31, 32 and 33.

The radiation fin parts 34, 35 and 36 are disposed spaced from one another at predetermined distances. A gap between adjacent fin plates 41, a gap between adjacent fin plates 42, and a gap between adjacent fin plates 43 may be air layers, or heat insulative material may be installed therein. Otherwise, spacers for holding the distances to be constant may be installed therein.

As above, by providing the gaps for spacing, interference of heat can be prevented even when the heat pipes 31, 32 and 33 are close to one another, which enables efficient cooling. Moreover, the gaps with predetermined distances allow air to flow therein to promote cooling.

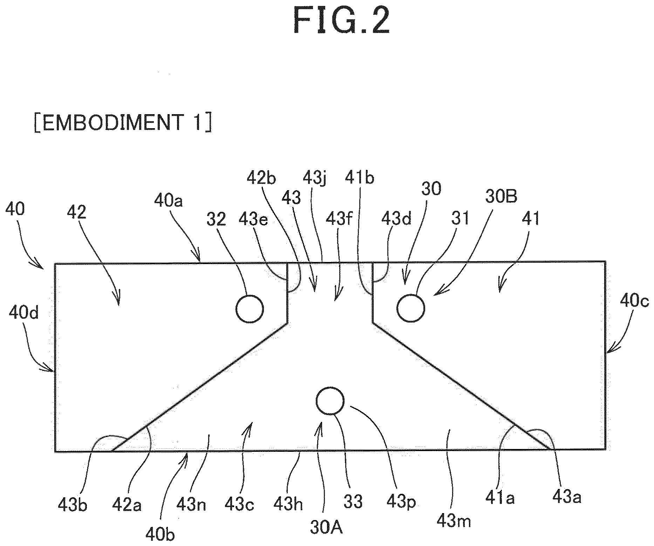

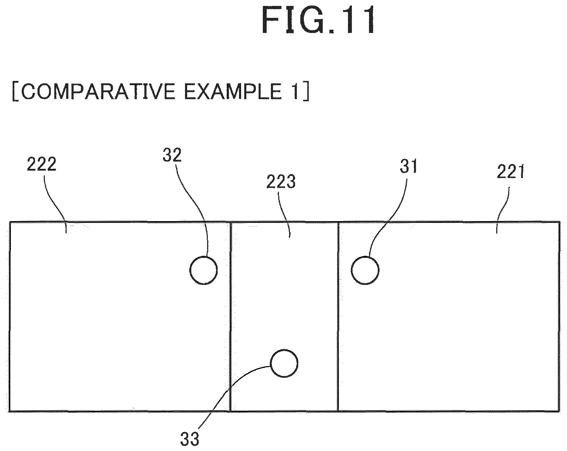

FIG. 2 is an elevation view showing the fin plates 41, 42 and 43 (Embodiment 1). Notably, predetermined gaps are provided between the fin plates 41, 42 and 43 (between the different fin plates) such that they do not interfere with each other (the same holds true for other fin plates mentioned later). FIG. 2 is described, compared with Comparative Example 1 shown in FIG. 11. FIG. 11 is an elevation view showing the fin plates 221, 222 and 223 (Comparative Example 1) of the conventional art shown in FIG. 10.

In Comparative Example 1 of FIG. 11, the heat pipes 31 and 32 form one line, and the heat pipe 33 is disposed on the straight line that passes the center between the heat pipes 31 and 32 and extends in the direction perpendicular to the direction in which the heat pipes 31 and 32 line up.

The rectangular fin plate 223 attached to the heat pipe 33 disposed at the center out of the three heat pipes 31, 32 and 33 is narrowest in width and smallest in area of the fin plates 221, 222 and 223. Moreover, although the areas of the fin plates 221 and 222 are larger than the area of the fin plate 223, parts, of the fin plates 221 and 222, close to the heat pipes 31 and 32 largely contribute cooling performance, and the cooling performance gradually decreases as departing from the heat pipes 31 and 32. Accordingly, the fin plates 221 and 222 includes many parts in which the cooling performance is low.

In Embodiment 1 shown in FIG. 2, the fin plates 41, 42 and 43 constitute a fin plate assembly 40 which is rectangular in elevation view, that is, as seen from the direction in which the heat pipes 31, 32 and 33 extend (other fin plate assemblies shown below are described in elevation view as seen from the direction in which the heat pipes extend similarly to the fin plate assembly 40). The fin plate assembly 40 includes two long sides 40a and 40b and two short sides 40c and 40d. The long sides 40a and 40b are formed along the direction in which the heat pipes 31, 32 and 33 line up (that is, the direction in which the heat pipes 31 and 32 line up).

The heat pipe group 30 is composed of a first heat pipe group 30A composed of the heat pipe 33 positioned at the center in the longitudinal direction of the fin plate assembly 40, and a second heat pipe group 30B composed of the heat pipes 31 and 32 disposed on both end part sides in the longitudinal direction of the fin plate assembly 40 with respect to the heat pipe 33. While each of the heat pipe groups 30A and 30B is constituted of a plurality of heat pipes, it may be constituted of one heat pipe.

The fin plate 43 is formed into an external form obtained by integrally combining a trapezoidal part 43c having oblique sides 43a and 43b on both sides of the heat pipe 33, and a rectangular part 43f which is adjacent to this trapezoidal part 43c and has lateral sides 43d and 43e on the inner sides of the heat pipes 31 and 32.

The heat pipe 33 is fixed to a fixing part 43p positioned at the center of the fin plate 43 in the longitudinal direction of the fin plate assembly 40.

The trapezoidal part 43c includes a bottom side 43h constituting the outer edge of the fin plate 43. The bottom side 43h is included in the long side 40b of the fin plate assembly 40. In this way, the fin plate 43 is formed so as to expand from the heat pipe 33 side to the bottom side 43h which is the outer edge.

The rectangular part 43f includes an upper side 43j constituting the outer edge of the fin plate 43. The upper side 43j is included in the long side 40a of the fin plate assembly 40.

The trapezoidal part 43c has expanding parts 43m and 43n which expand in the direction in which the heat pipes 31 and 32 line up (direction in which the long sides 40a and 40b extend) more than the rectangular part 43f.

The aforementioned expanding parts 43m and 43n are portions that have shapes in which the end part (specifically, the long side 40b side) of the radiation fin part 36 (see FIG. 1) is wider than the fixing part 43p to which the heat pipe 33 is fixed in the fin plate 43.

The fin plates 41 and 42 include oblique sides 41a and 42a provided so as to oppose the oblique sides 43a and 43b of the fin plate 43, and lateral sides 41b and 42b provided so as to oppose the lateral sides 43d and 43e of the fin plate 43.

The oblique sides 41a and 42a of the fin plates 41 and 42 and the oblique sides 43a and 43b of the fin plate 43 mentioned above may substantially go along the diagonal lines of the fin plate assembly 40.

Here, comparing Embodiment 1 in FIG. 2 with Comparative Example 1 in FIG. 11, in the fin plate 43, the radiation area close to the heat pipe 33 is increased, and thereby, cooling ability of the heat pipe 33 can be improved.

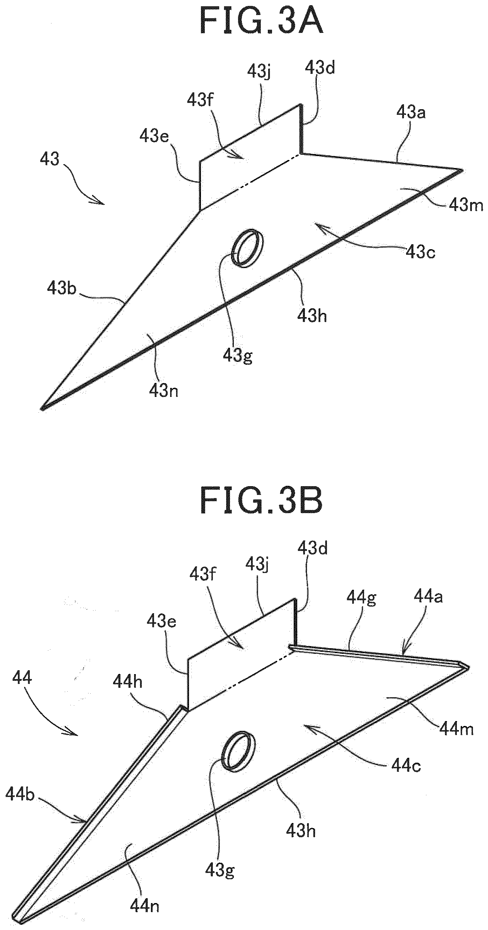

FIGS. 3A and 3B are perspective views for explaining the fin plate 43 (Embodiment 1) and a fin plate 44 (Modification). FIG. 3A is a perspective view showing the fin plate 43, and FIG. 3B is a perspective view showing the fin plate 44 which is a modification of the fin plate 43. Notably, as to the fin plate 44, the same configuration as that of the fin plate 43 is given the same sign and its detailed description is omitted.

The fin plate 43 shown in FIG. 3A has the oblique sides 43a and 43b in the lower trapezoidal part 43c. Hence, using these oblique sides 43a and 43b, folded parts 44g and 44h are formed in the fin plate 44 shown in FIG. 3B. Namely, the fin plate 44 is formed into an external form obtained by integrally combining a trapezoidal part 44c, as its lower part, having oblique sides 44a and 44b on both sides of the heat pipe 33 (see FIG. 1), and the rectangular part 43f, as its upper part, having the lateral sides 43d and 43e on the inner sides of the heat pipes 31 and 32(see FIG. 1), and includes the folded parts 44g and 44h substantially perpendicularly folded at the oblique sides 44a and 44b of the trapezoidal part 44c. Moreover, the trapezoidal part 44c has expanding parts 44m and 44n which expand in the direction in which the heat pipes 31 and 32(see FIG. 2B) line up more than the rectangular part 43f.

In FIGS. 3A and 3B, a fitting hole 43g into which the heat pipe 33 is press-fitted is bored in the trapezoidal parts 43c and 44c.

Operation of the fin plate 44 mentioned above is next described.

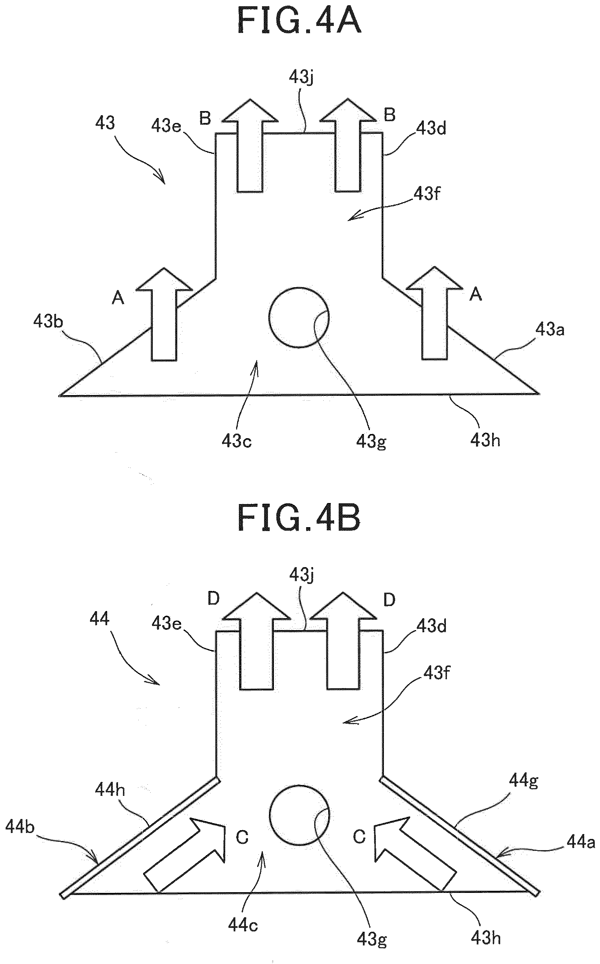

FIGS. 4A and 4B are operation diagrams for comparing operations in the presence and the absence of the folded parts 44g and 44h of the fin plate 44. FIG. 4A is an operation diagram showing operation of the fin plate 43, and FIG. 4B is an operation diagram showing operation of the fin plate 44.

As shown in FIG. 4A, as to the fin plate 43, when air flows along the fin plate 43, for example, from the bottom to the top of the fin plate 43, the air passes on the sides of the trapezoidal part 43c and the rectangular part 43f of the fin plate 43 as indicated by void arrows A and A and void arrows B and B to promote radiation from the fin plate 43.

On the contrary, as shown in FIG. 4B, as to the fin plate 44, when air flows along the fin plate 44, for example, from the bottom to the top of the fin plate 44, the air bumps against the folded parts 44g and 44h in the trapezoidal part 44c, and flows obliquely upward along the folded parts 44g and 44h as indicated by void arrows C and C to be collected to the center side of the fin plate 44. As a result, the air flow rate increases on the sides of the rectangular part 43f, and an upward flow as indicated by void arrows D and D is realized.

Accordingly, cooling with more air flow than in the case of FIG. 4A is realized in the rectangular part 43f, which can lead to more efficient cooling. Moreover, the rigidity of the fin plate 44 can be enhanced by providing the folded part 44g and 44h, and with the same plate thickness, the fin plate area can be increased, which can improve cooling performance. Furthermore, with the same area, the plate thickness can be made thin, which can realize light weight.

### (Embodiment 2)

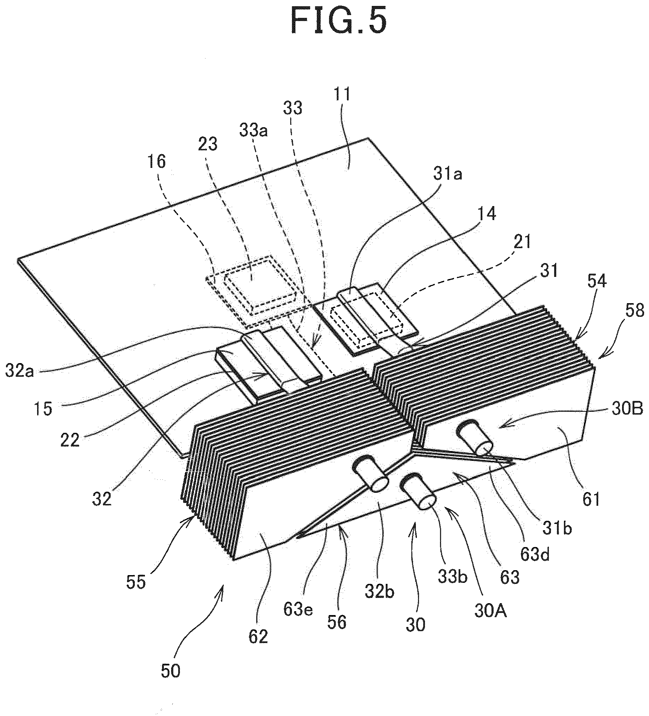

FIG. 5 is a perspective view showing a heat sink 50 (Embodiment 2) of the present invention. The same configuration as that of Embodiment 1 shown in FIG. 1 is given the same sign and its detailed description is omitted.

The heat sink 50 is different only in radiation fin parts 54, 55 and 56 with respect to the radiation fin parts 34, 35 and 36 (see FIG. 1) of the heat sink 10 (see FIG. 1). Namely, the heat sink 50 is constituted of the heat receiving plates 14, 15 and 16, the heat pipes 31, 32 and 33, and the radiation fin parts 54, 55 and 56. The three radiation fin parts 54, 55 and 56 constitute a radiation part 58 whose overall external form is formed into a substantially solid rectangular shape, and the radiation fin parts 54, 55 and 56 are composed of respective pluralities of fin plates 61, 62 and 63.

The fin plate 63 attached to the heat pipe 33 disposed at the center out of the three heat pipes 31, 32 and 33 is formed into a triangular shape.

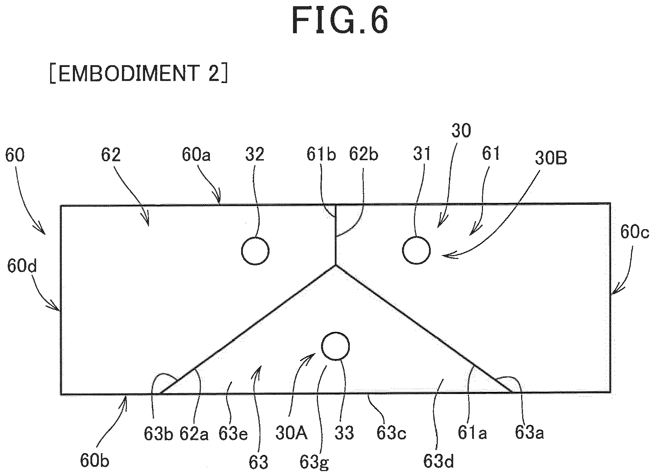

FIG. 6 is an elevation view showing the fin plates 61, 62 and 63 (Embodiment 2).

With respect to the fin plates 221, 222 and 223 shown in FIG. 11, the fin plates 61, 62 and 63 shown in FIG. 6 have different shapes with their areas being the same. Namely, the fin plate 221, the fin plate 222 and the fin plate 223 have the same areas as those of the fin plate 61, the fin plate 62 and the fin plate 63, respectively. Moreover, the fin plate 221 and the fin plate 61 have the same areas as those of the fin plate 222 and the fin plate 62, respectively.

In FIG. 6, the fin plates 61, 62 and 63 constitute a rectangular fin plate assembly 60. The fin plate assembly 60 includes two long sides 60a and 60b and two short sides 60c and 60d. The long sides 60a and 60b are formed along the direction in which the heat pipes 31, 32 and 33 line up (that is, the direction in which the heat pipes 31 and 32 line up).

The fin plate 63 is formed into an isosceles triangle having a vertex above the heat pipe 33, and includes two oblique sides 63a and 63b and a bottom side 63c. The bottom side 63c is included in the long side 60b of the fin plate assembly 60. In this way, the fin plate 63 is formed so as to expand from the heat pipe 33 side to the bottom side 63c which is the outer edge.

Moreover, the fin plate 63 has expanding parts 63d and 63e which expand in the direction in which the heat pipes 31 and 32 line up (direction in which the long sides 60a and 60b extend) more than the heat pipes 31 and 32.

The heat pipe 33 is fixed to a fixing part 63g positioned at the center of the fin plate 63 in the longitudinal direction of the fin plate assembly 60.

The aforementioned expanding parts 63d and 63e are portions which have shapes in which the end part (specifically, the long side 60b side) of the radiation fin part 56 (see FIG. 1) is wider than the fixing part 63g to which the heat pipe 33 is fixed in the fin plate 63.

The fin plates 61 and 62 include oblique sides 61a and 62a opposing the oblique sides 63a and 63b of the fin plate 63, and lateral sides 61b and 62b opposing each other.

The oblique sides 61a and 62a of the fin plates 61 and 62 and the oblique sides 63a and 63b of the fin plate 63 mentioned above may substantially go along the diagonal lines of the fin plate assembly 60.

Here, comparing Embodiment 2 in FIG. 6 with Comparative Example 1 in FIG. 11, in the fin plates 61, 62 and 63, the radiation areas close to the heat pipes 31, 32 and 33 are increased, and thereby, cooling ability of the heat pipes 31, 32 and 33 can be improved.

### <Experimental Examples>

For Embodiment 1, Embodiment 2 and Comparative Example 1 shown above, relation between the areas and shapes of the fin plates and the temperatures of the elements was evaluated under the following experimental conditions. The evaluation results are presented in Table 1.

### • Experimental Conditions

(a) The calorific values and sizes of the elements
   First element: 15 W, 20 mm × 15 mm
   Second element: 15 W, 30 mm × 30 mm
   Third element: 25 W, 20 mm × 20 mm

   For all of these, dummy elements in each of which a ceramic heater (MS-1, Sakaguchi E. H VOC Corporation) was attached to a copper block with the aforementioned size were used for measurement.
(b) The wind speed of cooling wind flowing from the top to the bottom of each fin plate: 1.5 m/s
(c) The thermal conductivity of thermal conductive grease between the element and the heat receiving plate: 6 W/mK
(d) The heat receiving plate: 30 mm × 30 mm of dimensions, 1 mm of plate thickness, and the material was nickel-plated aluminum alloy
(e) The joint part to the heat receiving plate in the heat pipe: was obtained by forming a copper pipe with 8 mm of diameter to be flat with 4 mm of thickness
(f) The fin plates: the material was aluminum alloy, 0.3 mm of plate thickness, 2 mm of pitch, the quantity per one heat pipe was 20
(g) The atmospheric temperature: 20 °C
(h) The load time: 30 min
(i) The sites of the temperatures measured: the surface temperatures of the first element, the second element and the third element
(j) The method of measuring the temperature: a thermocouple (K-6F, Sakaguchi E. H VOC Corporation) was installed in a groove formed on the surface of the dummy element, and the center temperature of the dummy element was measured

**[Table 1]**

| | Fin Plate Area cm² | | | Element Temperature °C | | | Determination |
|---|---|---|---|---|---|---|---|
| | Outside 1 | Outside 2 | Inside | First Element | Second Element | Third Element | |
| Comparative Example 1 | 100 | 100 | 50 | 35.9 | 34.5 | 53.7 | × |
| Embodiment 1 | 70 | 70 | 100 | 38.8 (+2.9) | 36.8 (+2.3) | 47.4 (-6.3) | ○ |
| Embodiment 2 | 100 | 100 | 50 | 33.9 (-2.0) | 33.1 (-1.4) | 49.1 (-4.6) | ○ |

| | | | | | | | |
|---|---|---|---|---|---|---|---|
| Note: Changes in temperature with respect to Comparative Example 1 are indicated in parentheses. | | | | | | | |

As a result, in Comparative Example 1 (also see FIG. 10 and FIG. 11), since the temperature of the third element 23 is 53.7 °C and exceeds the allowable maximum temperature, 50 °C, the determination is × (disqualified). Accordingly, for example, the output of the elements is needed to be reduced, or the wind speed of the cooling wind is needed to be increased using a high power cooling fan.

Meanwhile, in Embodiment 1 (also see FIG. 1 and FIG. 2), the area of the fin plate 43 can be made twice as large as the area of the fin plate 223 (see FIG. 11) by forming the oblique sides 43a and 43b in the fin plate 43, which is formed so as to expand from the heat pipe 33 side to the bottom side 43h which is the outer edge. As a result, the temperature of the third element 23 is 47.4 °C and can be reduced by 6.3 °C as compared with that in Comparative Example 1. Moreover, since it is not more than 50 °C, the determination is ○ (qualified). Moreover, as compared with the fin plates 221 and 222 (see FIG. 11), in the fin plates 41 and 42, portions in which cooling performance is low are eliminated. Thus, although the temperatures of the first element 21 and the second element 22 are increased, the temperature differences between the elements 21, 22 and 23 become small, and the areas can be optimized.

In Embodiment 2 (also see FIG. 5 and FIG. 6), the areas of the fin plates 61, 62 and 63 are the same as those in Comparative Example 1. Nevertheless, as compared with the Comparative Example 1, the temperatures of the elements 21, 22 and 23 are changed by -2.0 °C for the first element 21, by -1.4 °C for the second element 22, and by -4.6 °C for the third element 23, and the temperatures of all the elements 21, 22 and 23 can be reduced. Accordingly, determination is ○ (qualified).

Other embodiments of the fin plate shapes mentioned above are shown below.

### (Embodiment 3, Embodiment 4, Embodiment 5 and Comparative Example 2)

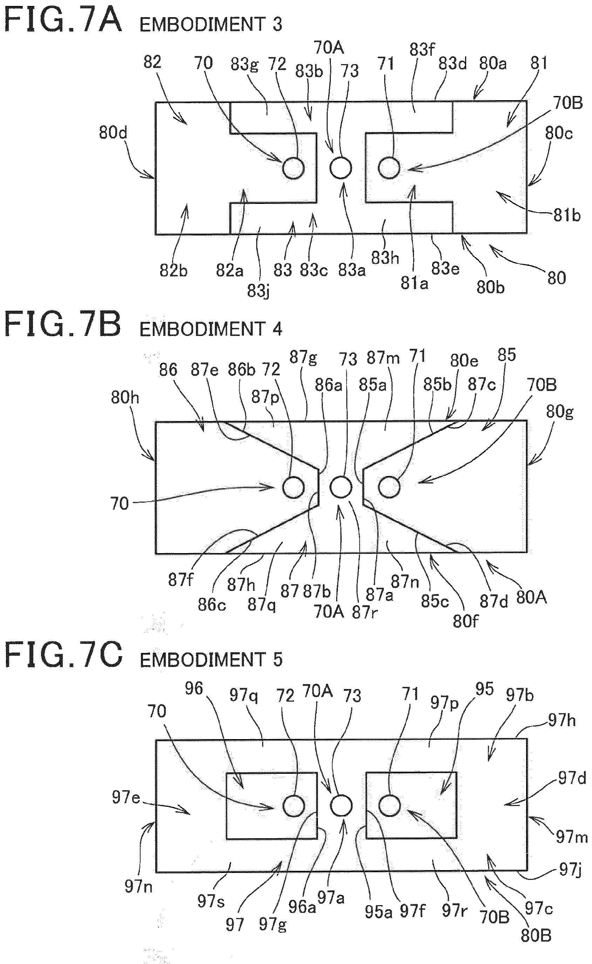

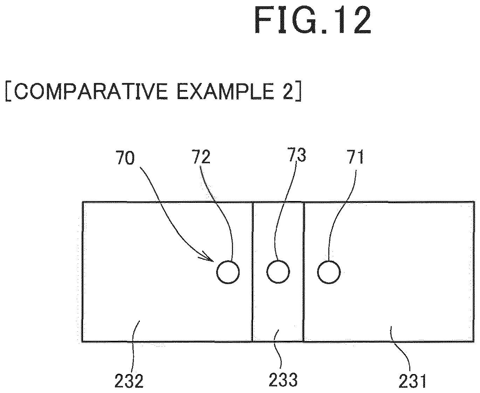

FIGS. 7A to 7C are elevation views showing fin plate shapes (Embodiment 3, Embodiment 4 and Embodiment 5) corresponding to three heat pipes 71, 72 and 73 that are arranged in one line. FIG. 7A is a view showing Embodiment 3 in which each of fin plates 81, 82 and 83 is constituted of a plurality of rectangles. FIG. 7B is an elevation view showing Embodiment 4 in which fin plates 85, 86 and 87 are formed so as to expand from the inside to the outside. FIG. 7C is an elevation view showing Embodiment 5 in which a fin plate 97 on one side is formed so as to enclose fin plates 95 and 96 on the other side. FIGS. 7A to 7C are described, compared with Comparative Example 2 shown in FIG. 12. FIG. 12 is an elevation view showing Comparative Example 2 which is a conventional art in which each of fin plates 231, 232 and 233 is formed into a rectangle.

As shown in FIG. 12, the heat pipes 71, 72 and 73 are closely disposed to one another and constitute a heat pipe group 70. Divisions between the heat pipes 71 and 73 and between the heat pipes 72 and 73 form the rectangular fin plates 231, 232 and 233. The width of the fin plate 233 out of the three fin plates 231, 232 and 233 is smallest and the area thereof is smallest.

As shown in FIG. 7A, the fin plates 81, 82 and 83 constitute a rectangular fin plate assembly 80, and the fin plate assembly 80 has long sides 80a and 80b and short sides 80c and 80d.

The heat pipe group 70 is composed of a first heat pipe group 70A composed of the heat pipe 73 positioned at the center of the fin plate assembly 80 in the longitudinal direction, and a second heat pipe group 70B composed of the heat pipes 71 and 72 disposed on both end part sides of the fin plate assembly 80 in the longitudinal direction with respect to the heat pipe 73. While each of the heat pipe groups 70A and 70B is constituted of a plurality of heat pipes, it may be constituted of one heat pipe.

The fin plate 81 is composed of an inner rectangular part 81a extending from the heat pipe 71 in the direction in which the heat pipes 71, 72 and 73 line up, and an outer rectangular part 81b which is wider than this inner rectangular part 81a and extends outward integrally from the inner rectangular part 81a.

Likewise, the fin plate 82 is composed of an inner rectangular part 82a extending from the heat pipe 72 in the direction in which the heat pipes 71, 72 and 73 line up, and an outer rectangular part 82b which is wider than this inner rectangular part 82a and extends outward integrally from the inner rectangular part 82a.

The fin plate 83 is composed of an inner rectangular part 83a extending from the heat pipe 73 in the direction perpendicular to the direction in which the heat pipes 71, 72 and 73 line up (upward and downward in the figure), and outer rectangular parts 83b and 83c which are wider than this inner rectangular part 83a and extend outward integrally from the inner rectangular part 83a. The outer rectangular parts 83b and 83c include an upper side 83d and a lower side 83e, respectively, included in the long sides 80a and 80b. In this way the fin plate 83 is formed so as to expand from the heat pipe 73 side to the upper side 83d or the lower side 83e which are the outer edges.

The fin plate 83 has expanding parts 83f, 83g, 83h and 83j which expand in the direction in which the heat pipes 71, 72 and 73 line up (direction in which the long sides 80a and 80b extend) more than the inner rectangular part 83a.

The fin plate assembly 80 is formed into a rectangle having the long sides 80a and 80b along the direction in which the heat pipes 71, 72 and 73 line up.

The heat pipe 73 is fixed to the inner rectangular part 83a which is a fixing part positioned at the center of the fin plate assembly 80 in the longitudinal direction in the fin plate 83.

The aforementioned expanding parts 83f, 83g, 83h and 83j are portions that have shapes in which the end parts (specifically, the long sides 80a and 80b sides) of the fin plate assembly 80 are wider than the inner rectangular part 83a to which the heat pipe 73 is fixed in the fin plate 83.

As shown in FIG. 7B, the fin plates 85, 86 and 87 constitute a rectangular fin plate assembly 80A, and the fin plate assembly 80A includes long sides 80e and 80f and short sides 80g and 80h.

The fin plate 85 is formed into a substantial fan shape which extends from the heat pipe 71 in the direction in which the heat pipes 71, 72 and 73 line up, and includes a lateral side 85a formed between the heat pipes 71 and 73, and oblique sides 85b and 85c extending from both end parts of this lateral side 85a obliquely to the direction in which the heat pipes 71, 72 and 73 line up.

Likewise, the fin plate 86 is formed into a substantial fan shape which extends from the heat pipe 72 in the direction in which the heat pipes 71, 72 and 73 line up, and includes a lateral side 86a formed between the heat pipes 72 and 73, and oblique sides 86b and 86c extending from both end parts of this lateral side 86a obliquely to the direction in which the heat pipes 71, 72 and 73 line up.

The fin plate 87 includes lateral sides 87a and 87b which are formed so as to expand from the heat pipe 73 in the direction perpendicular to the direction in which the heat pipes 71, 72 and 73 line up (upward and downward in the figure) and oppose the respective lateral sides 85a and 86a of the fin plates 85 and 86, oblique sides 87c, 87d, 87e and 87f which extend from both end parts of these lateral sides 87a and 87b, opposing the oblique sides 85b, 85c, 86b and 86c of the fin plates 85 and 86, and an upper side 87g and a lower side 87h which are included in the long sides 80e and 80f. In this way, the fin plate 87 is formed so as to expand from the heat pipe 73 side to the upper side 87g and the lower side 87h which are the outer edges.

Moreover, the fin plate 87 has expanding parts 87m, 87n, 87p and 87q which expand in the direction in which the heat pipes 71, 72 and 73 line up (direction in which the long sides 80e and 80f extend) more than between the lateral sides 87a and 87b.

The fin plate assembly 80A is formed into a rectangle which has the long sides 80e and 80f along the direction in which the heat pipes 71, 72 and 73 line up. The oblique sides 85b and 85c of the fin plate 85, the oblique sides 86b and 86c of the fin plate 86, and the oblique sides 87c, 87d, 87e and 87f of the fin plate 87 may go along the diagonal lines of the rectangular fin plate assembly 80A.

The heat pipe 73 is fixed to a fixing part 87r positioned at the center of the fin plate assembly 80A in the longitudinal direction in the fin plate 87 and between the lateral sides 87a and 87b.

The aforementioned expanding parts 87m, 87n, 87p and 87q are portions that have shapes in which the end parts (specifically, the long sides 80e and 80f sides) of the fin plate assembly 80A are wider than the fixing part 87r (specifically, the width between the lateral sides 87a and 87b) to which the heat pipe 73 is fixed in the fin plate 87.

As shown in FIG. 7C, the fin plates 95, 96 and 97 constitute a rectangular fin plate assembly 80B, and the fin plate assembly 80B includes long sides 97h and 97j and short sides 97m and 97n which are the same as in the fin plate 97.

The fin plate 95 is formed into a rectangle which extends from the heat pipe 71 in the direction in which the heat pipes 71, 72 and 73 line up, and includes a lateral side 95a formed between the heat pipes 71 and 73. Likewise, the fin plate 96 is formed into a rectangle which extends from the heat pipe 72 in the direction in which the heat pipes 71, 72 and 73 line up, and includes a lateral side 96a formed between the heat pipes 72 and 73.

The fin plate 97 is obtained by integrally forming an inner rectangular part 97a disposed between the fin plates 95 and 96 so as to enclose the heat pipe 73, outer rectangular parts 97b and 97c formed on both sides of this inner rectangular part 97a to be wider than the inner rectangular part 97a, and outer end part rectangular parts 97d and 97e disposed outside the fin plates 95 and 96 and between these outer rectangular parts 97b and 97c.

The inner rectangular part 97a includes lateral sides 97f and 97g opposing the lateral sides 95a and 96a of the fin plates 95 and 96. The outer rectangular part 97b includes the long side 97h, and the outer rectangular part 97c includes the long side 97j. The outer end part rectangular parts 97d and 97e, along with the outer rectangular parts 97b and 97c, form the short sides 97m and 97n with parts of their outer edges. Namely, the fin plate 97 includes the long sides 97h and 97j and the short sides 97m and 97n, and its external form is rectangular.

In this way, the fin plate 97 is formed so as to expand from the heat pipe 73 side to the long sides 97h and 97j which are the outer edges.

The outer rectangular parts 97b and 97c have expanding parts 97p, 97q, 97r and 97s which expand in the direction in which the heat pipes 71, 72 and 73 line up (direction in which the long sides 97h and 97j extend) more than the inner rectangular part 97a.

The heat pipe 73 is fixed to the inner rectangular part 97a as a fixing part positioned at the center in the longitudinal direction in the fin plate 97.

The aforementioned expanding parts 97p, 97q, 97r and 97s are portions that have shapes in which the end parts (specifically, the long sides 97h and 97j sides) of the fin plate 97 are wider than the inner rectangular part 97a to which the heat pipe 73 is fixed in the fin plate 97.

In FIGS. 7A to 7C and FIG. 12 above, the fin plate 83 of Embodiment 3, the fin plate 87 of Embodiment 4, and the fin plate 97 of Embodiment 5 are larger in area than the fin plate 233 of Comparative Example 2, and moreover, can increase the radiation area close to the heat pipe 73 and improve radiation ability.

### (Embodiment 6 and Comparative Example 3)

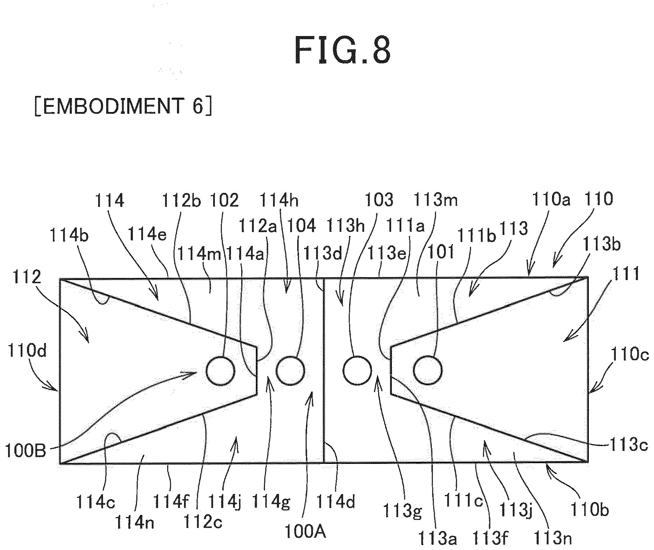

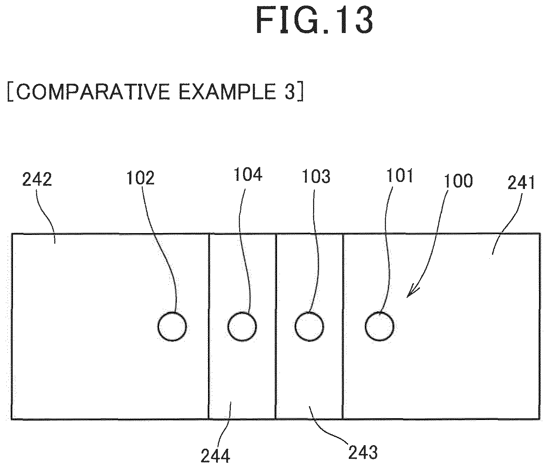

FIG. 8 is an elevation view showing fin plate shapes (Embodiment 6) corresponding to four heat pipes 101, 102, 103 and 104 that are arranged in one line. FIG. 8 is described, compared with Comparative Example 3 shown in FIG. 13. FIG. 13 is an elevation view showing Comparative Example 3 which is a conventional art in which each of fin plates 241, 242, 243 and 244 is formed into a rectangle.

As shown in FIG. 13, the heat pipes 101, 102, 103 and 104 are closely disposed to one another and constitute a heat pipe group 100. Divisions between the heat pipes 101 and 103, between the heat pipes 103 and 104 and between the heat pipes 102 and 104 form the rectangular fin plates 241, 242, 243 and 244. The widths of the fin plates 243 and 244 out of the four fin plates 241, 242, 243 and 244 are smallest and the areas thereof are smallest.

As shown in FIG. 8, the fin plates 111, 112, 113 and 114 are formed so as to expand from the inside to the outside.

The fin plates 111, 112, 113 and 114 constitute a rectangular fin plate assembly 110, and the fin plate assembly 110 has long sides 110a and 110b and short sides 110c and 110d.

The heat pipe group 100 includes a first heat pipe group 100A composed of the heat pipes 103 and 104 positioned at the center in the longitudinal direction of the fin plate assembly 110, and a second heat pipe group 100B composed of the heat pipes 101 and 102 disposed on both end part sides in the longitudinal direction of the fin plate assembly 110 with respect to the heat pipes 103 and 104. Each of the heat pipe groups 100A and 70B is constituted of a plurality of heat pipes.

The fin plate 111 is formed into a substantial fan shape which extends from the heat pipe 101 in the direction in which the heat pipes 101, 102, 103 and 104 line up, and includes a lateral side 111a formed between the heat pipes 101 and 103, and oblique sides 111b and 111c extending from both end parts of this lateral side 111a obliquely to the direction in which the heat pipes 101, 102, 103 and 104 line up.

Likewise, the fin plate 112 is formed into a substantial fan shape which extends from the heat pipe 102 in the direction in which the heat pipes 101, 102, 103 and 104 line up, and includes a lateral side 112a formed between the heat pipes 102 and 104, and oblique sides 112b and 112c extending from both end parts of this lateral side 112a obliquely to the direction in which the heat pipes 101, 102, 103 and 104 line up.

The aforementioned oblique sides 111b, 111c, 112b and 112c of the fin plates 111 and 112 extend along the diagonal lines of the fin plate assembly 110.

The fin plate 113 is composed of a rectangular part 113g which is formed so as to expand from the heat pipe 103 in the direction perpendicular to the direction in which the heat pipes 101, 102, 103 and 104 line up (upward and downward in the figure) and encloses the heat pipe 103, and trapezoidal parts 113h and 113j integrally formed outside this rectangular part 113g.

Moreover, the fin plate 113 includes a lateral side 113a opposing the lateral side 111a of the fin plate 111, oblique sides 113b and 113c extending from both end parts of this lateral side 113a, opposing the oblique sides 111b and 111c of the fin plate 111, a lateral side 113d formed between the heat pipes 103 and 104, an upper side 113e included in the long side 110a, and a lower side 113f included in the long side 110b.

Furthermore, the fin plate 113 has expanding parts 113m and 113n which expand in the direction in which the heat pipes 101, 102, 103 and 104 line up (direction in which the long sides 110a and 110b extend) more than between the lateral sides 113a and 113d.

Likewise, the fin plate 114 includes a rectangular part 114g which is formed so as to expand from the heat pipe 104 in the direction perpendicular to the direction in which the heat pipes 101, 102, 103 and 104 line up (upward and downward in the figure) and encloses the heat pipe 104, and trapezoidal parts 114h and 114j integrally formed outside this rectangular part 114g.

Moreover, the fin plate 114 includes a lateral side 114a opposing the lateral side 112a of the fin plate 112, oblique sides 114b and 114c extending from both end parts of this lateral side 114a, opposing the oblique sides 112b and 112c of the fin plate 112, a lateral side 114d which is formed between the heat pipes 103 and 104 and opposes the lateral side 113d of the fin plate 113, an upper side 114e included in the long side 110a, and a lower side 114f included in the long side 110b.

Furthermore, the fin plate 114 has expanding parts 114m and 114n which expand in the direction in which the heat pipes 101, 102, 103 and 104 line up (direction in which the long sides 110a and 110b extend) more than between the lateral sides 114a and 114d.

The aforementioned oblique sides 113b, 113c, 114b and 114c of the fin plates 113 and 114 extend along the diagonal lines of the fin plate assembly 110.

The heat pipes 103 and 104 are fixed to the rectangular parts 113g and 114g as fixing parts positioned at the center in the longitudinal direction of the fin plate assembly 80 in the fin plates 113 and 114.

The aforementioned expanding parts 113m, 113n, 114m and 114n are portions that have shapes in which the end parts (specifically, the long sides 110a and 110b sides) of the fin plate assembly 110 are wider that the rectangular parts 113g and 114g to which the heat pipes 103 and 104 are fixed in the fin plates 113 and 114.

As mentioned above, the fin plates 113 and 114 are formed so as to expand from the heat pipes 103 and 104 sides to the upper sides 113e and 114e and the lower sides 113f and 114f which are the outer edges.

Moreover, in FIG. 8 and FIG. 13, the fin plates 113 and 114 of Embodiment 6 are larger in area than the fin plates 243 and 244 of Comparative Example 3, moreover, can increase the radiation areas close to the heat pipes 103 and 104, and thereby, can improve radiation ability.

### (Embodiment 7, Embodiment 8 and Comparative Example 4)

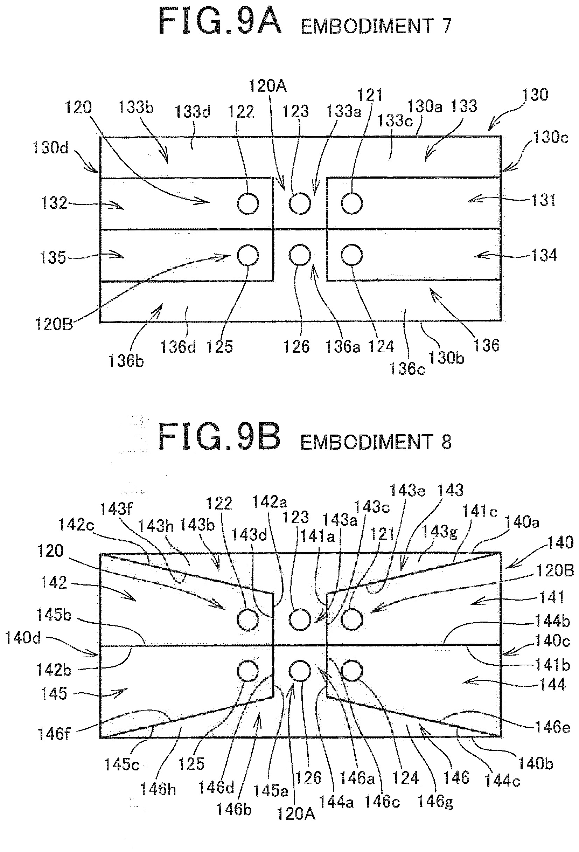

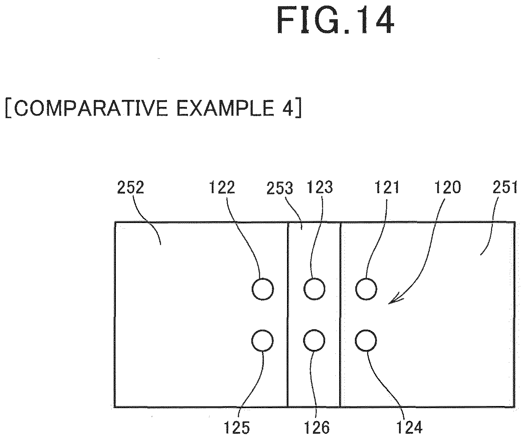

FIGS. 9A and 9B are elevation views showing fin plate shapes (Embodiment 7 and Embodiment 8) corresponding to six heat pipes 121, 122, 123, 124, 125 and 126 that are arranged in two lines. FIG. 9A is an elevation view showing Embodiment 7 in which each of fin plates 131, 132, 133, 134, 135 and 136 is constituted of a single rectangle or a plurality of rectangles. FIG. 9B is an elevation view showing Embodiment 8 in which fin plates 141, 142, 143, 144, 145 and 146 are formed so as to expand from the inside to the outside. FIGS. 9A and 9B are described, compared with Comparative Example 4 shown in FIG. 14. FIG. 14 is an elevation view showing Comparative Example 4 which is a conventional art in which each of fin plates 251, 252 and 253 is formed into a rectangle.

As shown in FIG. 14, the heat pipes 121, 122, 123, 124, 125 and 126 are closely arranged to one another and constitute a heat pipe group 120. The fin plate 251 is attached to two heat pipes 121 and 124, the fin plate 252 is attached to two heat pipes 122 and 125, and the fin plate 253 is attached to two heat pipes 123 and 126. Divisions between the heat pipes 121 and 124 and the heat pipes 123 and 126 and between the heat pipes 123 and 126 and the heat pipes 122 and 125 form the rectangular fin plates 251, 252 and 253. The width of the fin plate 253 out of the three fin plates 251, 252 and 253 is smallest and the area thereof is smallest.

As shown in FIG. 9A, the fin plates 131, 132, 133, 134, 135 and 136 constitute a rectangular fin plate assembly 130, and the fin plate assembly 130 includes long sides 130a and 130b and short sides 130c and 130d.

The heat pipe group 120 is composed of a first heat pipe group 120A composed of the heat pipes 123 and 126 positioned at the center in the longitudinal direction of the fin plate assembly 130, and a second heat pipe group 120B composed of the heat pipes 121, 122, 124 and 125 disposed on both end sides in the longitudinal direction of the fin plate assembly 130 with respect to the heat pipes 123 and 126. Each of the heat pipe groups 120A and 120B is constituted of a plurality of heat pipes.

The fin plates 131 and 132 are formed into rectangles so as to extend from the heat pipes 121 and 122 in the direction in which the heat pipes 121, 122 and 123 line up.

The fin plate 133 is composed of an inner rectangular part 133a interposed between the fin plates 131 and 132, and an outer rectangular part 133b which is wider than this inner rectangular part 133a and extends outward integrally from the inner rectangular part 133a.

Moreover, the fin plate 133 has expanding parts 133c and 133d which expand in the direction in which the heat pipes 121, 122 and 123 line up (direction in which the long sides 130a and 130b extend) more than the inner rectangular part 133a.

The fin plates 134 and 135 are formed into rectangles so as to extend from the heat pipes 124 and 125 in the direction in which the heat pipes 124, 125 and 126 line up.

The fin plate 136 is composed of an inner rectangular part 136a interposed between the fin plates 134 and 135, and an outer rectangular part 136b which is wider than this inner rectangular part 136a and extends outward integrally from the inner rectangular part 136a.

Moreover, the fin plate 136 has expanding parts 136c and 136d which expand in the direction in which the heat pipes 124, 125 and 126 line up (direction in which the long sides 130a and 130b extend) more than the inner rectangular part 136a.

The fin plate 133 includes the long side 130a, and the fin plate 136 includes the long side 130b. Moreover, edge parts of the fin plates 131, 133, 134 and 136 form the short side 130c, and edge parts of the fin plates 132, 133, 135 and 136 form the short side 130d.

The heat pipes 123 and 126 are fixed to the inner rectangular parts 133a and 136a as fixing parts positioned at the center in the longitudinal direction of the fin plate assembly 130 in the fin plates 133 and 136.

The aforementioned expanding parts 133c, 133d, 136c and 136d are portions that have shapes in which the end parts (specifically, the long sides 130a and 130b sides) of the fin plate assembly 130 are wider than the inner rectangular parts 133a and 136a to which the heat pipes 123 and 126 are fixed in the fin plates 133 and 136.

In this way, the fin plates 133 and 136 are formed so as to expand from the heat pipes 123 and 126 sides to the long sides 130a and 130b which are the outer edges.

As shown in FIG. 9B, the fin plates 141, 142, 143, 144, 145 and 146 constitute a rectangular fin plate assembly 140, and the fin plate assembly 140 includes long sides 140a and 140b and short sides 140c and 140d.

The fin plate 141 is formed into a substantial fan shape which extends from the heat pipe 121 in the direction in which the heat pipes 121, 122 and 123 line up, and includes a lateral side 141a formed between the heat pipes 121 and 123, a lower side 141b extending from one end part of this lateral side 141a in the direction in which the heat pipes 121, 122 and 123 line up, and an oblique side 141c extending from the other end part of the lateral side 141a obliquely to the direction in which the heat pipes 121, 122 and 123 line up.

Likewise, the fin plate 142 is formed into a substantial fan shape which extends from the heat pipe 122 in the direction in which the heat pipes 121, 122 and 123 line up, and includes a lateral side 142a formed between the heat pipes 122 and 123, a lower side 142b extending from one end part of this lateral side 142a in the direction in which the heat pipes 121, 122 and 123 line up, and an oblique side 142c extending from the other end part of the lateral side 142a obliquely to the direction in which the heat pipes 121, 122 and 123 line up.

The fin plate 143 is composed of a rectangular part 143a disposed between the fin plates 141 and 142, and a trapezoidal part 143b formed so as to expand integrally from this rectangular part 143a in the direction perpendicular to the direction in which the heat pipes 121, 122 and 123 line up. The rectangular part 143a includes lateral sides 143c and 143d opposing the lateral sides 141a and 142a of the fin plates 141 and 142. The trapezoidal part 143b includes oblique sides 143e and 143f opposing the oblique sides 141c and 142c of the fin plates 141 and 142, and the long side 140a is its bottom side.

Moreover, the fin plate 143 has expanding parts 143g and 143h which expand in the direction in which the heat pipes 121, 122 and 123 line up (direction in which the long sides 140a and 140b extend) more than the rectangular part 143a.

The fin plate 144 is formed into a substantial fan shape which extends from the heat pipe 124 in the direction in which the heat pipes 124, 125 and 126 line up, and includes a lateral side 144a formed between the heat pipes 124 and 126, an upper side 144b extending from one end part of this lateral side 144a in the direction in which the heat pipes 124, 125 and 126 line up, and an oblique side 144c extending from the other end part of the lateral side 144a obliquely to the direction in which the heat pipes 124, 125 and 126 line up.

Likewise, the fin plate 145 is formed into a substantial fan shape which extends from the heat pipe 125 in the direction in which the heat pipes 124, 125 and 126 line up, and includes a lateral side 145a formed between the heat pipes 125 and 126, an upper side 145b extending from one end part of this lateral side 145a in the direction in which the heat pipes 124, 125 and 126 line up, and an oblique side 145c extending from the other end part of the lateral side 145a obliquely to the direction in which the heat pipes 124, 125 and 126 line up.

The fin plate 146 is composed of a rectangular part 146a disposed between the fin plates 144 and 145, and a trapezoidal part 146b formed so as to expand integrally from this rectangular part 146a in the direction perpendicular to the direction in which the heat pipes 124, 125 and 126 line up. The rectangular part 146a includes lateral sides 146c and 146d opposing the lateral sides 144a and 145a of the fin plates 144 and 145. The trapezoidal part 146b includes oblique sides 146e and 146f opposing the oblique sides 144c and 145c of the fin plates 144 and 145, and the long side 140b is its bottom side.

Moreover, the fin plate 146 has expanding parts 146g and 146h which expand in the direction in which the heat pipes 124, 125 and 126 (direction in which the long sides 140a and 140b extend) more than the rectangular part 146a.

The oblique side 141c of the fin plate 141, the oblique side 142c of the fin plate 142, the oblique sides 143e and 143f of the fin plate 143, the oblique side 144c of the fin plate 144, the oblique side 145c of the fin plate 145, and the oblique sides 146e and 146f of the fin plate 146 mentioned above may go along the diagonal lines of the rectangle formed of the outer edges of the fin plate assembly 140.

The heat pipes 123 and 126 are fixed to the rectangular parts 143a and 146a as fixing parts positioned at the center in the longitudinal direction of the fin plate assembly 140 in the fin plates 143 and 146.

The aforementioned expanding parts 143g, 143h, 146g and 146h are portions that have shapes in which the end parts (specifically, the long sides 140a and 140b sides) of the fin plate assembly 140 are wider than the rectangular parts 143a and 146a to which the heat pipes 123 and 126 are fixed in the fin plates 143 and 146.

As mentioned above, the fin plates 143 and 146 are formed so as to expand from the heat pipes 123 and 126 sides to the long sides 140a and 140b which are the outer edges.

Moreover, in FIGS. 9A and 9B and FIG. 14, the fin plates 133 and 136 of Embodiment 7, and the fin plates 143 and 146 of Embodiment 8 are larger in area than the upper or lower half of the fin plate 253 of Comparative Example 4, moreover, can increase the radiation areas close to the heat pipes 123 and 126, and thereby, can improve radiation ability.

As shown in FIG. 1 and FIG. 2 above, a heat sink is composed of a plurality of heat pipes 31, 32 and 33 and radiation fin parts 34, 35 and 36 corresponding to the plurality of respective heat pipes 31, 32 and 33, the radiation fin parts 34, 35 and 36 being fixed to respective end parts of the plurality of heat pipes 31, 32 and 33 in the longitudinal direction, each of the plurality of radiation fin parts 34, 35 and 36 being composed of a plurality of fin plates 41, 42, 43, gaps being formed between adjacent fin plates 41, between adjacent fin plates 42 and between adjacent fin plates 43, wherein the fin plate 41, 42, 43 has a fixing part 43p for thermal connection to the heat pipe 31, 32, 33, and at least one heat pipe 31, 32, 33 is fixed to each fin plate 41, 42, 43, a rectangular fin plate assembly 40 is constituted of the fin plate 41, the fin plate 42 and the fin plate 43 of the plurality of respective radiation fin parts 34, 35 and 36 as the plurality of radiation fin parts 34, 35 and 36 are seen from the direction in which the heat pipe 31, 32, 33 extends, the plurality of heat pipes 31, 32 and 33 are composed of a first heat pipe group 30A and a second heat pipe group 30B, the first heat pipe group 30A is positioned at the center in the longitudinal direction of the fin plate assembly 40, and the second heat pipe group 30B is positioned on both sides of the first heat pipe group 30A in the longitudinal direction of the fin plate assembly 40, and the fin plate 43 thermally connected to the first heat pipe group 30A includes expanding parts 43m and 43n.

Moreover, as shown in FIG. 1 and FIG. 2, in the heat sink 10 constituted of: the heat receiving plates 14, 15 and 16 to which the first element 21, the second element 22 and the third element 23 as heat generating bodies are thermally connected; the heat pipe group 30 composed of the plurality of heat pipes 31, 32 and 33 whose one end parts 31a, 32a and 33a are connected to these heat receiving plates 14, 15 and 16, to the other end parts 31b, 32b and 33b of which heat is transferred from the one end parts 31a, 32a and 33a, and which are closely disposed to one another; and the radiation fin parts 34, 35 and 36 composed of the fin plates 41, 42 and 43 thermally connected respectively to the other end parts 31b, 32b and 33b of the plurality of heat pipes 31, 32 and 33, the fin plates 41, 42 and 43 are attached to each of the heat pipes 31, 32 and 33, and the fin plate 43 attached to the heat pipe 33 as an inner heat pipe disposed on the center side of the heat pipe group 30 out of the heat pipes 31, 32 and 33 is formed so as to expand from the heat pipe 33 side to the bottom side 43h as a part of the outer edge of the fin plate 43.

With this configuration, the area of the fin plate 43 connected to the heat pipe 33 can be increased, the areas of the fin plates 41, 42 and 43 required for the respective heat pipes 31, 32 and 33 by nature can be given, and the areas of the fin plates 41, 42 and 43 can be optimized. As a result, cooling performance of the heat sink 10 as an assembly of those can be improved. Furthermore, excess fin areas of the fin plates 41 and 42 connected to the outer heat pipes 31 and 32 can be reduced, and hence, the heat sink 10 can be made small as a whole.

Moreover, in the case where the plurality of heat pipes 31, 32 and 33 are made straight pipes, even when the heat pipes 31, 32 and 33 are closely disposed to one another, the heat pipes 31, 32 and 33 can be manufactured at low costs while cooling performance of the heat sink 10 is improved.

The overall external form of the fin plates 41, 42 and 43 attached to the plurality of heat pipes 31, 32 and 33 is rectangular, and hence, the fin plates 41, 42 and 43 can be efficiently disposed in the space.

Moreover, the rectangle has the long sides 40a and 40b or the short sides 40c and 40d such that they go along the direction in which the plurality of heat pipes 31, 32 and 33 are arranged, and hence, the heat pipes 31, 32 and 33 can be disposed substantially at the centers of the respective fin plates 41, 42 and 43, which can realize more uniform radiation to the peripheries of the heat pipes 31, 32 and 33. Moreover, the radiation fin parts 34, 35 and 36 can be easily closely disposed to one another and the heat sink 10 can be easily assembled.

Moreover, as shown in FIG. 8, since parts of the edge parts of the fin plates 111, 112, 113 and 114, that is, the oblique sides 111b, 111c, 112b and 112c of the fin plates 111 and 112 and the oblique sides 113b, 113c, 114b and 114c of the fin plates 113 and 114 extend along the diagonal lines of the rectangular fin plate assembly 110, the fin plate areas close to the heat pipes 101, 102, 103 and 104 can be easily enlarged.

Moreover, as shown in FIG. 2, FIG. 3B and FIG. 4B, since in the fin plate 44, the oblique sides 44a and 44b as the edge parts extending substantially along the diagonal lines of the rectangle are substantially perpendicularly folded, air flowing along the fin plate 44 can be collected by the folded parts 44g and 44h which are folded, and the air can be effectively blown onto the fin plate 44, which can lead to increase of the air flow rate and efficient cooling of the fin plate 44. Moreover, folding the edge parts can improve the rigidity of the fin plate 44 and make it hardly deformed. As a result, the plate thickness of the fin plate 44 can be formed to be thinner, which can make the fin plate 44 lightweight.

Moreover, as shown in FIG. 7A, since the fin plate 83 is formed into a shape obtained by combining the inner rectangular part 83a and the outer rectangular parts 83b and 83c as a plurality of rectangles, costs can be reduced by a simple shape with the area of the fin plate 83 increased.

The aforementioned embodiments merely show modes of the present invention, and their arbitrary modifications and applications may occur without departing from the spirit of the present invention.

For example, the overall external form of the fin plate assembly may be an incomplete rectangle, and its corner parts may be formed into arc shapes or beveled shapes. Moreover, a part of the fin plate assembly may be cut out.

Moreover, while for the embodiments, modes in which the expanding part is provided in the fin plate disposed at the center are mainly described, not limited to these, in the case where the element position is displaced from the site where the fins can be installed or the similar case, the expanding part may be provided in the fin plate of the heat sink at the end part to secure the required area.

### Reference Signs List

10, 50 Heat sink
30A, 70A, 100A, 120A First heat pipe group
30B, 70B, 100B, 120B Second heat pipe group
31, 32, 3371, 72, 73, 101, 102, 103, 104, 121, 122, 123, 124, 125, 126Heat pipe
34, 34, 36, 54, 55, 56 Radiation fin part
40, 60, 80, 80A, 80B, 110, 130, 140 Fin plate assembly
41, 42, 43, 61, 62, 63, 75, 76, 77, 81, 82, 83, 85, 86, 87, 95, 96, 97, 111, 112, 113, 114, 131, 132, 133, 134, 135, 136, 141, 142, 143, 144, 145, 146 Fin plate
43m, 43n, 44m, 44n, 63d, 63e, 83f, 83g, 83h, 83j, 87m, 87n, 87p, 87q, 97p, 97q, 97r, 97s, 113m, 113n, 114m, 114n, 133c, 133d, 136c, 136d, 143g, 143h, 146g, 146h Expanding part
43p, 63g, 87rFixing part
83a, 97a, 133a, 136a Inner rectangular part (fixing part)
113g, 114g, 143a, 146a Rectangular part (fixing part)

## Claims

1. A heat sink (10), comprising:
a plurality of heat pipes (31, 32, 33); and
radiation fin parts (34, 35, 36) respectively corresponding to the plurality of heat pipes (31, 32, 33), the radiation fin parts (34, 35, 36) being fixed to respective end parts (31b, 32b, 33b) of the plurality of heat pipes (31, 32, 33) in a longitudinal direction, wherein
each radiation fin part (34, 35, 36) of the radiation fin parts is composed of a plurality of fin plates (41, 42, 43) and a gap is formed between adjacent fin plates of the plurality of fin plates (41, 42, 43) belonging to different radiation fin parts,
each fin plate (41, 42, 43) of the plurality of fin plates (41, 42, 43) has a fixing part (43p) for thermal connection to the corresponding heat pipe of the plurality of heat pipes (31, 32, 33),
at least one heat pipe (31, 32, 33) of the plurality of heat pipes (31, 32, 33) is fixed to each fin plate of the plurality of fin plates (41, 42, 43),
a fin plate assembly (40) is constituted of the plurality of fin plates (41, 42, 43) of the plurality of respective radiation fin parts (34, 35, 36) as seen from a direction in which the corresponding heat pipe of the plurality of heat pipes (31, 32, 33) extends,
the plurality of heat pipes (31, 32, 33) are composed of a first heat pipe group (30A) and a second heat pipe group (30B) ,
each heat pipe (33) and corresponding radiation fin part (36) of the first heat pipe group (30A) are disposed to line up with each other and each heat pipe (31, 32) and corresponding radiation fin part (34, 35) of the second heat pipe group (30B) are disposed to line up with each other,
a first fin plate (43) of the plurality of fin plates (41, 42, 43) that is thermally connected to the first heat pipe group (30A) includes an expanding part (43m), and **characterized in that**
the first fin plate (43) is configured such that a first area (43f), at a periphery of the fixing part (43p), is smaller than a second area (43c), occupied by the expanding part (43m) of the first fin plate (43), which increases a radiation area close to the corresponding heat pipe (33).

2. The heat sink (10) according to Claim 1, wherein at least one side of the expanding part (43m) is parallel to at least one side of the fin plate assembly (40).

3. The heat sink (10) according to Claim 1, wherein at least one side (43a) of the expanding part (43m) is oblique to at least one side of the fin plate assembly (40).

4. The heat sink (10) according to any one of Claims 1 to 3, wherein a part of one side in the expanding part (43m) is folded (44g).

5. The heat sink (10) according to any one of Claims 1 to 4, wherein every heat pipe (31, 32, 33) of the plurality of heat pipes (31, 32, 33) is of a straight line shape.

6. The heat sink (10) according to any one of Claims 1 to 5, wherein the first heat pipe group (30A) is positioned at a center in a longitudinal direction of the fin plate assembly (40), and the second heat pipe group (30B) is positioned on sides of the first heat pipe group (30A) in the longitudinal direction of the fin plate assembly (40).

7. The heat sink (10) according to any one of Claims 1 to 6, wherein an end part (40b), of a radiation fin part (36) including the first fin plate (43), is wider than the fixing part (43p) to which the heat pipe (33) is fixed in the first fine plate (43).

8. The heat sink (10) according to any one of Claims 1 to 7, wherein the first fin plate (43) is formed into an external form obtained by integrally combining the first area (43f) and the second area (43c) of the first fin plate (43).

9. The heat sink (10) according to any one of Claims 1 to 8, wherein
the first fin plate (43) further includes a second expanding part (43n),
the expanding part (43m) and the second expanding part (43n) are disposed in a direction in which each heat pipe (33) of the first heat pipe group (30A) line up,
the expanding part (43m) and the second expanding part (43n) are spaced apart from the fixing part (43p), and
the expanding parts (43m, 43n) expand from a heat pipe (33) side to an outer edge side of the first fin plate (43).

## Patentansprüche

1. Kühlkörper (10), umfassend:
eine Mehrzahl von Wärmerohren (heat pipes) (31, 32, 33); und
Teile von Strahlungsrippen (34, 35, 36) jeweils entsprechend zu der Mehrzahl von Wärmerohren (31, 32, 33), wobei die Teile von Strahlungsrippen (34, 35, 36) am jeweiligen Endteil (31b, 32b 33b) von der Mehrzahl von Wärmerohren (31, 32, 33) in einer Längsrichtung fixiert sind, wobei
jeder Teil einer Strahlungsrippe (34, 35, 36) von den Teilen von Strahlungsrippen aus einer Mehrzahl von Rippenplatten (41, 42, 43) zusammengesetzt ist und ein Spalt zwischen benachbarten Rippenplatten aus der Mehrzahl der Rippenplatten ( 41, 42, 43) gebildet wird, die zu verschiedenen Teilen von Strahlungsrippen gehören,
jede Rippenplatte (41, 42, 43) von der Mehrzahl von Rippenplatten (41, 42, 43) einen Befestigungsteil (43p) für die thermische Verbindung zu dem entsprechenden Wärmerohr von der Mehrzahl von Wärmerohren (31, 32, 33) aufweist,
zumindest ein Wärmerohr (31, 32, 33) von der Mehrzahl von Wärmerohren (31, 32, 33) an jeder Rippenplatte von der Mehrzahl von Rippenplatten (41, 42, 43) angebracht ist,
eine Rippenplattenanordnung (40) aus der Mehrzahl von Rippenplatten (41, 42, 43) von der Mehrzahl der jeweilige Teile von Strahlungsrippen (34, 35, 36) gebildet wird, wie aus einer Richtung gesehen, in welcher sich das entsprechenden Wärmerohr von die Mehrzahl von Wärmerohren (31, 32, 33) erstreckt,
die Mehrzahl von Wärmerohren (31, 32, 33) aus einer ersten Wärmerohrgruppe (30A) und einer zweiten Wärmerohrgruppe (30B) zusammengesetzt ist,
jedes Wärmerohr (33) und entsprechende Teile von Strahlungsrippen (36) von der ersten Wärmerohrgruppe (30A) so angeordnet sind, dass sie sich aneinander ausrichten und jedes Wärmerohr (31, 32) und entsprechende Teile von Strahlungsrippen (34, 35) von der zweiten Wärmerohrgruppe (30B) so angeordnet sind, dass sie sich aneinander ausrichten,
eine erste Rippenplatte (43) aus der Mehrzahl von Rippenplatten (41, 42, 43), die thermisch mit der ersten Wärmerohrgruppe (30A) verbunden ist, einen expandierenden Teil (43m) umfasst, und **dadurch gekennzeichnet ist, dass**
die erste Rippenplatte (43) so konfiguriert ist, dass ein erster Bereich (43f), an einer Peripherie von dem Befestigungsteil (43p), kleiner ist als ein zweiter Bereich (43c), der durch den expandierenden Teil (43m) von den ersten Rippenplatte (43) belegt ist, wodurch ein Strahlungsbereich nahe dem entsprechenden Wärmerohr (33) vergrößert wird.

2. Wärmekörper (10) nach Anspruch 1, wobei zumindest eine Seite von dem expandierenden Teil (43m) parallel zu zumindest einer Seite von der Rippenplattenanordnung (40) ist.

3. Wärmekörper (10) nach Anspruch 1, wobei zumindest eine Seite (43a) von dem expandierenden Teil (43m) schräg zu zumindest einer Seite von der Rippenplattenanordnung (40) angeordnet ist.

4. Wärmekörper (10) nach einem der Ansprüche 1 bis 3, wobei ein Teil von einer Seite in dem expandierenden Teil (43m) gefaltet (44 g) ist.

5. Wärmekörper (10) nach einem der Ansprüche 1 bis 4, wobei jedes Wärmerohr (31, 32, 33) von der Mehrzahl von Wärmerohren (31, 32, 33) die Form einer geraden Linie aufweist.

6. Wärmekörper (10) nach einem der Ansprüche 1 bis 5, wobei die erste Wärmerohrgruppe (30A) in einer Mitte in Längsrichtung von der Rippenplattenanordnung (40) positioniert ist, und die zweite Wärmerohrgruppe (30B) auf Seiten von dem ersten Wärmerohrgruppe (30A) in Längsrichtung von der Rippenplattenanordnung (40) positioniert ist.

7. Wärmekörper (10) nach einem der Ansprüche 1 bis 6, wobei ein Endteil (40b) von einem Teil von Strahlungsrippen (36) einschließlich der ersten Rippenplatte (43) breiter ist als der Befestigungsteil (43p) an dem das Wärmerohr (33) in der ersten Rippenplatte (43) befestigt ist.

8. Wärmekörper (10) nach einem der Ansprüche 1 bis 7, wobei die erste Rippenplatte (43) zu einer äußeren Form gebildet ist, indem der erste Bereich (43f) und der zweite Bereich (43c) von der ersten Rippenplatte (43) integral miteinander kombiniert werden.

9. Wärmekörper (10) nach einem der Ansprüche 1 bis 8, wobei
die erste Rippenplatte (43) weiter einen zweiten expandierenden Teil (43n) umfasst,
der expandierende Teil (43m) und der zweite expandierende Teil (43n) in einer Richtung angeordnet sind, in welcher jedes Wärmerohr (33) von der ersten Wärmerohrgruppe (30A) ausgerichtet ist,
der expandierende Teil (43m) und der zweite expandierende Teil (43n) im Abstand von dem Befestigungsteil (43P) angeordnet sind, und
die expandierenden Teile (43m, 43n) sich von einer Wärmerohr (33) - Seite bis zu einer äußeren Randseite von der ersten Rippenplatte (43) erstrecken.

## Revendications

1. Dissipateur de chaleur (10), comprenant :
une pluralité de tubes caloporteurs (31, 32, 33) ; et
des pièces formant ailettes rayonnantes (34, 35, 36) correspondant respectivement à la pluralité de tubes caloporteurs (31, 32, 33), les pièces formant ailettes rayonnantes (34, 35, 36) étant fixées à des parties terminales respectives (31b, 32b, 33b) de la pluralité de tubes caloporteurs (31, 32, 33) dans une direction longitudinale,
dans lequel
chaque pièce formant ailette rayonnante (34, 35, 36) parmi les pièces formant ailettes rayonnantes est composée d'une pluralité de plaques-ailettes (41, 42, 43) et un intervalle est formé entre plaques-ailettes adjacentes de la pluralité de plaques-ailettes (41, 42, 43) appartenant à différentes pièces formant ailettes rayonnantes,
chaque plaque-ailette (41, 42, 43) de la pluralité de plaques-ailettes (41, 42, 43) comprend une partie de fixation (43p) pour une liaison thermique au tube caloporteur correspondant de la pluralité de tubes caloporteurs (31, 32, 33),
au moins un tube caloporteur (31, 32, 33) de la pluralité de tubes caloporteurs (31, 32, 33) est fixé à chaque plaque-ailette de la pluralité de plaques-ailettes (41, 42, 43),
un assemblage de plaques-ailettes (40) est constitué par la pluralité de plaques-ailettes (41, 42, 43) de la pluralité de pièces respectives formant ailettes rayonnantes (34, 35, 36) telles que vues depuis une direction dans laquelle le tube caloporteur correspondant de la pluralité de tubes caloporteurs (31, 32, 33) s'étend,
la pluralité de tubes caloporteurs (31, 32, 33) sont composés d'un premier groupe de tubes caloporteurs (30A) et d'un second groupe de tubes caloporteurs (30B),
chaque tube caloporteur (33) et chaque pièce formant ailette rayonnante (36) correspondante du premier groupe de tubes caloporteurs (30A) sont disposés en alignement l'un avec l'autre et chaque tube caloporteur (31, 32) et chaque pièce formant ailette rayonnante (34, 35) correspondante du second groupe de tubes caloporteurs (30B) sont disposés en alignement l'un avec l'autre,
une première plaque-ailette (43) de la pluralité de plaques-ailettes (41, 42, 43) qui est reliée thermiquement au premier groupe de tubes caloporteurs (30A) inclut une partie en expansion (43m),
et **caractérisé en ce que**
la première plaque-ailette (43) est configurée de telle façon qu'une première zone (43f), à une périphérie de la partie de fixation (43p), est plus petite qu'une seconde zone (43c), occupée par la partie en expansion (43m) de la première plaque-ailettes (43), qui augmente une zone de rayonnement proche du tube caloporteur (33) correspondant.

2. Dissipateur de chaleur (10) selon la revendication 1, dans lequel au moins un côté de la partie en expansion (43m) est parallèle à au moins un côté de l'assemblage de plaques-ailettes (40).

3. Dissipateur de chaleur (10) selon la revendication 1, dans lequel au moins un côté (43a) de la partie en expansion (43m) est en oblique par rapport à au moins un côté de l'assemblage de plaques-ailettes (40).

4. Dissipateur de chaleur (10) selon l'une quelconque des revendications 1 à 3, dans lequel une partie d'un côté dans la partie en expansion (43m) est plié (44g).

5. Dissipateur de chaleur (10) selon l'une quelconque des revendications 1 à 4, dans lequel chaque tube caloporteur (31, 32, 33) de la pluralité de tubes caloporteurs (31, 32, 33) a une forme en ligne droite.

6. Dissipateur de chaleur (10) selon l'une quelconque des revendications 1 à 5, dans lequel le premier groupe de tubes caloporteurs (30A) est positionné au niveau d'un centre dans une direction longitudinale de l'assemblage de plaques-ailettes (40), et le second groupe de tubes caloporteurs (30B) est positionné sur les côtés du premier groupe de tubes caloporteurs (30A) dans la direction longitudinale de l'assemblage de plaques-ailettes (40).

7. Dissipateur de chaleur (10) selon l'une quelconque des revendications 1 à 6,
dans lequel une partie terminale (40b), d'une pièce formant ailette rayonnante (36) incluant la première plaque-ailette (43), est plus large que la partie de fixation (43p) à laquelle le tube caloporteur (33) est fixé dans la première plaque-ailette (43).

8. Dissipateur de chaleur (10) selon l'une quelconque des revendications 1 à 7, dans lequel la première plaque-ailette (43) est formée avec une forme externe obtenue en combinant de façon intégrale la première zone (43f) et la seconde zone (43c) de la première plaque-ailette (43).

9. Dissipateur de chaleur (10) selon l'une quelconque des revendications 1 à 8, dans lequel
la première plaque-ailette (43) inclut en outre une seconde partie en expansion (43n),
la partie en expansion (43m) et la seconde partie en expansion (43n) sont disposées dans une direction dans laquelle chaque tube caloporteur (33) du premier groupe de tubes caloporteurs (30A) est aligné,
la partie en expansion (43m) et la seconde partie en expansion (43n) sont espacées depuis la partie de fixation (43p), et
les parties en expansion (43m, 43n) sont en expansion depuis un côté du tube caloporteur (33) vers un côté de bordure extérieure de la première plaque-ailette (43).
